# EUROPÄISCHE PATENTSCHRIFT

(11) **EP 3 811 027 B1**
(45) Veröffentlichungstag und Bekanntmachung des Hinweises auf die Patenterteilung: **11.05.2022**
(21) Anmeldenummer: 18758533.6
(22) Anmeldetag: 21.06.2018
(51) Int. Cl.: G01B 11/24, G06T 17/20

(54) **VERFAHREN ZUM SPEICHERN VON REALDATEN EINER KÖRPERKONTUR EINES KÖRPERS**
METHOD FOR STORING REAL DATA RELATING TO A BODY CONTOUR OF A BODY
PROCÉDÉ DE MÉMORISATION DE DONNÉES RÉELLES D'UN CONTOUR DU CORPS D'UN CORPS

(43) Veröffentlichungstag der Anmeldung: 28.04.2021
(73) Patentinhaber: Fill Gesellschaft m.b.H., 4942 Gurten (AT)
(72) Erfinder: SEHRSCHÖN, Harald, 4924 Waldzell (AT); WIESINGER, Alois, 4675 Weibern (AT)
(74) Vertreter: Burger, Hannes
(86) Internationale Anmeldenummer: PCT/AT2018/060126
(87) Internationale Veröffentlichungsnummer: WO 2019/241809

(56) Entgegenhaltungen:
- DE-A1-102007 021 697
- DE-A1-102007 021 753
- US-A1- 2015 339 851

## Beschreibung

Die Erfindung betrifft ein Verfahren zum Speichern von Realdaten einer Körperkontur eines Körpers, sowie ein System zur Datenverarbeitung, eine Fertigungsanlage ein Computerprogrammprodukt und ein Computerlesbares Speichermedium zum Ausführen des Verfahrens.

Zur Qualitätssicherung ist es oft notwendig, dass zu gefertigten Bauteilen die tatsächlich gefertigte Geometrie vermessen und dem Bauteil eindeutig zugeordnet abgespeichert wird, um beispielsweise im Falle eines zukünftigen Bauteilversagens eine Evaluierung bzw. Fehlersuche durchführen zu können. Dies ist auch oft bei Serienproduktionen notwendig, wo eine Nachvollziehbarkeit der tatsächlich gefertigten Geometrie der Bauteile erforderlich sein kann.

Aus dem Stand der Technik sind diverse Verfahren zum Vermessen von gefertigten Bauteilen und zum Speichern der Messdaten bekannt. Hierbei wir die Oberfläche des Bauteils diskretisiert und in einzelne Punkte eines Oberflächengitters aufgeteilt, wobei das Oberflächengitter abgespeichert wird. Diese Verfahren weisen den Nachteil auf, dass bei Wahl einer hohen Auflösung des Oberflächengitters eine große Datenmenge gespeichert werden muss. Bei Wahl einer niedrigen Auflösung des Oberflächengitters ist die Genauigkeit des Oberflächengitters oft nur unzureichend. Eine adaptive Gittererzeugung beim Vermessen des Bauteiles ist nicht möglich, da nicht automatisiert erkannt werden kann, wo ein engmaschiges Gitter notwendig ist.

Aus der US 2015/339851 A1, der DE 10 2007 02 1697 A1 und der DE 10 2007 021753 A1 sind Verfahren zum Speichern von Realdaten einer Realkörperkontur eines Körpers bekannt.

Aufgabe der vorliegenden Erfindung war es, die Nachteile des Standes der Technik zu überwinden und ein Verfahren zur Verfügung zu stellen, mittels dem die Realdaten unter Verwendung von möglichst wenig Speicherplatz, jedoch mit ausreichend hoher Genauigkeit abgespeichert werden können.

Diese Aufgabe wird durch eine Vorrichtung und ein Verfahren gemäß den Ansprüchen gelöst.

Bei dem erfindungsgemäßen Verfahren handelt es sich zumindest in einzelnen Verfahrensschritten um ein computerimplementiertes Verfahren.

Erfindungsgemäß ist ein Verfahren zum Speichern von Realdaten einer Realkörperkontur eines Körpers vorgesehen. Das Verfahren umfasst die Verfahrensschritte:
- Erstellen eines Modelloberflächengitters mit mehreren Gitterpunkten, welches Modelloberflächengitter eine Modellkörperkontur abbildet, wobei das Modelloberflächengitter auf Basis von CAD-Daten eines virtuellen Körpers auf einem Computer erstellt wird, wobei zumindest einzelne Teilflächen der Gesamtoberfläche des virtuellen Körpers in einer Gittererzeugung separat diskretisiert werden;
- Fertigen des Körpers auf Basis der Modellkörperkontur der CAD-Daten;
- Eruieren von Realdaten des gefertigten Körpers;
- Erstellen einer Abbildung, insbesondere eines Realoberflächengitters, der Realkörperkontur auf Basis der Realdaten und anschließendes anpassen des Modelloberflächengitters der Modellkörperkontur an die Abbildung, insbesondere das Realoberflächengitter, der Realkörperkontur durch Verschieben von einzelnen Gitterpunkten des Modelloberflächengitters und dadurch Erstellen eines Speicheroberflächengitters zumindest eines Teils der Realkörperkontur mittels des Computers;
- Abspeichern des Speicheroberflächengitters auf einem Datenträger zur Weiterverarbeitung der Daten.

Weiters ist vorgesehen, dass die Realdaten des gefertigten Körpers durch Vermessen des gefertigten Körpers mittels eines Vermessungsmittels eruiert werden.

Darüber hinaus ist vorgesehen, dass während des Messvorganges das Modelloberflächengitter der Modellkörperkontur direkt an die Messdaten der Realkörperkontur durch Verschieben von einzelnen Gitterpunkten des Modelloberflächengitters an die jeweils vermessene Position der Realkörperkontur angepasst wird und dadurch ein Speicheroberflächengitter der Realkörperkontur mittels des Computers erstellt wird.

ist vorgesehen, das Verfahren zum Speichern von Vermessungsdaten einer Realkörperkontur eines Körpers folgende Verfahrensschritte umfasst:
- Erstellen eines Modelloberflächengitters mit mehreren Gitterpunkten, welches Modelloberflächengitter eine Modellkörperkontur abbildet, wobei das Modelloberflächengitter auf Basis von CAD-Daten eines virtuellen Körpers auf einem Computer erstellt wird, wobei zumindest einzelne Teilflächen der Gesamtoberfläche des virtuellen Körpers in einer adaptiven Gittererzeugung separat diskretisiert werden, um an unterschiedlichen Teilflächen eine unterschiedliche Auflösung des Modelloberflächengitters zur Verfügung zu stellen;
- Fertigen des Körpers auf Basis der Modellkörperkontur der CAD-Daten;
- Vermessen des gefertigten Körpers mittels einem Vermessungsmittel und
   a) Erstellen eines Realoberflächengitters der Realkörperkontur auf Basis der Vermessungsdaten und anschließendes anpassen des Modelloberflächengitters der Modellkörperkontur an das Realoberflächengitter der Realkörperkontur durch Verschieben von einzelnen Gitterpunkten des Modelloberflächengitters und dadurch Erstellen eines Speicheroberflächengitters der Realkörperkontur mittels des Computers;
   b) während des Messvorganges direktes anpassen des Modelloberflächengitters der Modellkörperkontur an die Messdaten der Realkörperkontur durch Verschieben von einzelnen Gitterpunkten des Modelloberflächengitters an die jeweils vermessene Position der Realkörperkontur und dadurch Erstellen eines Speicheroberflächengitters der Realkörperkontur mittels des Computers;
- Abspeichern des Speicheroberflächengitters auf einem Datenträger zur Weiterverarbeitung der Daten.

Das erfindungsgemäße Verfahren bringt den überraschenden Vorteil mit sich, dass die Dateigröße zum Speichern des Speicheroberflächengitters zum Speichern des Speicheroberflächengitters sehr gering ausfällt. Gleichzeitig weist das Speicheroberflächengitter in den relevanten Bereichen trotzdem eine ausreichende Genauigkeit auf. Dies kann dadurch erreicht werden, dass bereits beim Erstellen des Modelloberflächengitters jene Bereiche mit einer komplexen Kontur bzw. jene Bereiche in denen eine höhere Genauigkeit gefordert ist, mit einer höheren Auflösung diskretisiert werden können, als jene Bereiche der Modellkörperkontur, welche keine hohe Komplexität aufweisen bzw. welche mit einer hohen Genauigkeit gefertigt werden können bzw. bei welchen keine hohe Genauigkeit gefordert ist. Beim Vermessen des gefertigten Körpers bzw. beim Erstellen des Realoberflächengitters ist somit die Gitterstruktur des Modelloberflächengitters bereits bekannt, wodurch nur die einzelnen Gitterpunkte der Gitterstruktur des Modelloberflächengitters an die Gegebenheiten im gefertigten Körper angepasst werden müssen. Dies bringt nicht nur den Vorteil der geringeren notwendigen Speicherkapazität mit sich, sondern bringt auch den überraschenden Vorteil mit sich, dass das Vermessen des gefertigten Körpers einfach und effizient durchgeführt werden kann.

Weiters kann vorgesehen sein, dass das Modelloberflächengitter bzw. die Auflösung des Modelloberflächengitters beim Vermessen des gefertigten Körpers dazu verwendet wird, um dem Vermessungsmittel den notwendigen Abtastpfad vorzugeben bzw. um die Verfahrgeschwindigkeit bzw. die Auflösung des Vermessungsmittels entsprechend der Auflösung des Modelloberflächengitters zu steuern. Dies bringt den überraschenden Vorteil mit sich, dass nicht nur die Qualität der Vermessung, sondern auch die Geschwindigkeit der Vermessung verbessert werden kann.

Die alternativen Verfahrensschritte a und b des erfindungsgemäßen Verfahrens lösen beide dieselbe Aufgabe der Erfindung, nämlich das Bereitstellen eines Speicheroberflächengitters der Realkörperkontur des gefertigten Körpers, welches eine hohe Genauigkeit und dabei eine geringe Datenmenge aufweist.

Das Abspeichern des Speicheroberflächengitters auf einem Datenträger bringt den Vorteil mit sich, dass die Speicherdaten der Realkörperkontur des gefertigten Körpers für zukünftige Aufgabenstellungen bereitgehalten werden können. Insbesondere kann es notwendig sein, dass in einer Serienproduktion das Speicheroberflächengitter über ein Identifizierungsmerkmal, beispielsweise eine fortlaufende Nummerierung, eindeutig dem jeweils vermessenen Körper zuordenbar ist.

Weiters kann vorgesehen sein, dass jede einzelne Teilfläche der Gesamtoberfläche des virtuellen Körpers in einer adaptiven Gittererzeugung separat diskretisiert wird. Hierbei kann jeder einzelnen Oberfläche eine eigene Auflösung zugeordnet werden.

Weiters kann es zweckmäßig sein, wenn beim Abspeichern des Speicheroberflächengitters die Absolutkoordinaten der Gitterpunkte des Speicheroberflächengitters abgespeichert werden. Dies bring den Vorteil mit sich, dass das Speicheroberflächengitter unabhängig vom Modelloberflächengitter in jedem Programm geöffnet werden kann bzw. in jedem entsprechenden Programm zur Verfügung steht.

Alternativ dazu kann vorgesehen sein, dass beim Abspeichern des Speicheroberflächengitters lediglich die Verschiebungswerte der Gitterpunkte des Speicheroberflächengitters in Relation zum Modelloberflächengitter abgespeichert werden. Dies bringt insbesondere in der Großserienfertigung Vorteile mit sich, da durch diese Maßnahme die Datenmenge des Speicheroberflächengitters weiter reduziert werden kann. Insbesondere kann beispielsweise vorgesehen sein, dass nur zu jenen Gitterpunkten des Speicheroberflächengitters auch Dateneinträge angelegt werden, welche eine Abweichung zum Modelloberflächengitter aufweisen.

Darüber hinaus kann vorgesehen sein, dass auf Basis des Modelloberflächengitters der Modellkörperkontur eine Simulation durchgeführt wird und dass in einem weiteren Verfahrensschritt das Modelloberflächengitter der Modellkörperkontur durch das Speicheroberflächengitter der Realkörperkontur ersetzt wird und die Simulation mittels der Daten des Speicheroberflächengitters der Realkörperkontur für den jeweiligen gefertigten Körper oder Verbund aus mehreren gefertigten Körpern angepasst oder erneut durchgeführt wird. Dies bringt den überraschenden Vorteil mit sich, dass die Datenmenge bzw. die Rechenleistung zur Simulation der tatsächlich gefertigten Körper möglichst geringgehalten werden kann. Ein weiterer Vorteil liegt darin, dass die Daten des tatsächlich gefertigten Körpers eine Beurteilung der Eignung zur Verwendung in ihrem Einsatzgebiet zulassen. Insbesondere durch die beschriebenen Verfahrensschritte kann das Modelloberflächengitter in der Simulation einfach durch das Speicheroberflächengitter ersetzt werden, da beide Oberflächengitter eine ähnliche Datenstruktur aufweisen, wobei lediglich die Gitterpunkte teilweise geringfügig verschoben sind.

Beispielsweise kann vorgesehen sein, dass in einem ersten Verfahrensschritt eine Fertigungsmaschine in einem CAD-Programm konstruiert wird. Auf Basis dieser CAD-Daten der virtuellen Fertigungsmaschine können die einzelnen Bauteile der virtuellen Fertigungsmaschine diskretisiert werden, sodass entsprechende Modelloberflächengitter für Simulationen erzeugt werden können. Die Modelloberflächengitter werden anschließend in ein Simulationsmodell übertragen, um die Simulation durchführen zu können. Derartige Simulationen können beispielsweise Festigkeitssimulationen, Schwingungssimulationen, Strömungssimulationen, Wärmeleitungssimulationen oder dergleichen sein. Bei einzelnen Bauteilen kann hierbei das Bauteilverhalten simuliert werden. Bei Modellen von komplexen Fertigungsmaschinen kann beispielsweise das Verhalten der Fertigungsmaschine bzw. das Aussehen des Produktes eines auf dieser Fertigungsmaschine produzierten Produktes simuliert werden. Beispielsweise kann die mechanische Bearbeitung an einem Produkt simuliert werden und dabei die in der Fertigungsmaschine auftretenden Schwingungen simuliert werden. Dadurch kann beispielsweise eine mögliche zu erzeugende Oberfläche eines Produktes simuliert werden. Weiters können beispielsweise auch Strömungen oder Wärmeleitungen in Gießprozessen simuliert werden. Somit lässt sich beispielsweise der Schweißtemperaturverlauf, insbesondere die Abkühlzeit t8/5 im Schweißprozess simulieren.

In einem weiteren Verfahrensschritt können beispielsweise die einzelnen Körper der obig beschriebenen Fertigungsmaschine gefertigt und entsprechend dem erfindungsgemäßen Verfahren vermessen und die Messdaten abgespeichert werden. Hierbei ist es natürlich auch möglich, dass die Fertigungsmaschine, die zum Fertigen der Körper dient, selbst schon in dem hier beschriebenen Prozess vermessen wurde bzw. für diese ein Simulationsmodell besteht.

In einem anschließenden Verfahrensschritt kann das bereits erstellte Simulationsmodell, welches auf Basis der CAD-Daten der virtuellen und somit idealen Fertigungsmaschine oder eines virtuellen Produktes erstellt wurde, einfach durch die Realkörperkontur der gefertigten Fertigungsmaschine oder des gefertigten Produktes ersetzt werden und somit die Simulation einfach angepasst werden. Dies wird, wie schon beschrieben dadurch begünstigt, dass der grundsätzliche Aufbau des Modelloberflächengitters und des Speicheroberflächengitter seine einheitliche Datenstruktur aufweisen und nur die Gitterpunkte teilweise verschoben sind.

Durch die angeführten Maßnahmen ist es somit einfach möglich, ein Simulationsmodell für eine Maschine, welche in Serie gefertigt werden soll, zu erstellen und anschließend mit möglichst geringem Rechen- bzw. Bearbeitungsaufwand das einmalig erstellte Simulationsmodell an die tatsächlich gefertigte Bearbeitungsanlage anzupassen. Somit können für jede tatsächlich gefertigte Bearbeitungsanlage Simulationsmodelle bereitgestellt werden, mittels denen eine Simulation der Bearbeitung bzw. der Fertigung eines Werkstückes auf der Bearbeitungsanlage durchgeführt werden kann.

Vorteilhaft ist auch eine Ausprägung, gemäß welcher vorgesehen sein kann, dass beim Diskretisieren des virtuellen Körpers eine Auflösung des Modelloberflächengitters in jenen Bereichen in denen eine Schweißnaht vorgesehen ist, feiner ist, als eine Auflösung des Modelloberflächengitters in jenen Bereichen des virtuellen Körpers, in denen keine Schweißnaht vorgesehen ist. Dadurch kann der Tatsache Rechnung getragen werden, dass Schweißnähte bei der Herstellung im Vergleich zu den restlichen Oberflächen meist eine geringe Genauigkeit bzw. eine komplexe Oberfläche aufweisen.

Weiters kann vorgesehen sein, dass die Daten des Realoberflächengitters gelöscht werden, sobald die Daten des Speicheroberflächengitters abgespeichert sind.

Gemäß einer Weiterbildung ist es möglich, dass dem Anpassen des Modelloberflächengitters der Modellkörperkontur an die Abbildung, insbesondere das Realoberflächengitter, der Realkörperkontur ein Verfahrensschritt zum Ausrichten der Abbildung vorgelagert ist, wobei an der Modellkörperkontur zumindest eine Referenzfläche oder Referenzpunkte festgelegt werden, welche am Körper die höchste Fertigungsgenauigkeit aufweisen und dass die Abbildung der Realkörperkontur bezüglich dessen Lage an die Referenzpunkte interpoliert wird, um die Abbildung der Realkörperkontur weitestgehend mit dem Modelloberflächengitter bezüglich dessen Orientierung und/oder Lage auszurichten. Dies ist besonders dann vorteilhaft, wenn einzelne Referenzflächen bzw. Referenzpunkte eine hohe Positionsgenauigkeit aufweisen, welche in diesem Fall genutzt werden kann.

Alternativ dazu kann auch vorgesehen sein, dass am Körper ein Referenzobjekt angeordnet wird, welches zur Bestimmung der Ausrichtung und Lage des Körpers dient.

Alternativ dazu kann vorgesehen sein, dass vor dem Anpassen des Modelloberflächengitters der Modellkörperkontur an die Abbildung, insbesondere das Realoberflächengitter, der Realkörperkontur ein Verfahrensschritt zum Ausrichten der Abbildung der Realkörperkontur vorgelagert ist, wobei das Modelloberflächengitter derart bezüglich dessen Orientierung und/oder Lage gedreht und/oder verschoben wird, dass über die Gesamtoberfläche betrachtet ein Abstand zwischen dem Modelloberflächengitter und der Abbildung der Realkörperkontur möglichst gering ist. Dieses Verfahren kann auch als Best-Fit-Verfahren bezeichnet werden. Hierbei werden das Realoberflächengitter und das Modelloberflächengitter bestmöglich in Übereinstimmung gebracht, um anschließen das Speicheroberflächengitter möglichst wenig gegenüber dem Modelloberflächengitter durch Verschiebung von Gitterpunkten anpassen zu müssen.

In einer weiteren Alternative kann vorgesehen sein, dass der Körper beim Vermessen in einer vordefinierten Position bzw. Orientierung in einer Spannaufnahme gespannt ist, sodass der zu vermessende Körper bezüglich dessen Position bzw. Orientierung bereits beim Vermessen richtig angeordnet ist. Somit ist es nicht notwendig, dass die Lage des Körpers referenziert wird, da diese durch die Spannaufnahme vorgegeben ist.

Weiters kann vorgesehen sein, dass zum Ausrichten oder Einpassen der Abbildung der Realkörperkontur an das Modelloberflächengitter, insbesondere im Best-Fit-Verfahren, ein Optimierungsalgorithmus, wie etwa ein künstliches neuronales Netz, verwendet wird. Besonders für derartige Einpassprozesse sind künstliche neuronale Netze gut geeignet.

Weiters kann vorgesehen sein, dass am Modelloberflächengitter der Modellkörperkontur eine Abweichungstoleranz definiert ist und dass ein Signal ausgegeben wird, wenn die Messwerte des Körpers oder die Abbildung, insbesondere das Realoberflächengitter, der Realkörperkontur zumindest bereichsweise außerhalb der Abweichungstoleranz des Modelloberflächengitters der Modellkörperkontur liegt. Durch diese Maßnahme kann dem Benutzer eine außerhalb der Toleranz liegende Abweichung des Körpers signalisiert werden.

Das Signal zum Anzeigen des Überschreitens der Abweichungstoleranz kann beispielsweise ein akustisches oder auch ein optisches Signal sein. Weiters ist es auch denkbar, dass das Signal beim Überschreiten der Abweichungstoleranz ausschließlich computerintern weiterverarbeitet wird.

Gemäß einer besonderen Ausprägung ist es möglich, dass das Vermessungsmittel zum Vermessen des gefertigten Körpers ein optisches Erfassungsmittel, insbesondere ein handgeführtes optisches Erfassungsmittel, umfasst. Besonders mittels eines optischen Erfassungsmittels lassen sich Bauteile effizient und einfach vermessen.

Weiters kann vorgesehen sein, dass bereits beim Vermessen des gefertigten Körpers und Erstellen eines Realoberflächengitters einer Realkörperkontur der Verfahrensschritt zum Ausrichten des Realoberflächengitters ausgeführt wird, wobei am Modelloberflächengitter der Modellkörperkontur eine Abweichungstoleranz definiert ist und wobei ein Signal ausgegeben wird, wenn das Realoberflächengitter der Realkörperkontur bereichsweise außerhalb der Abweichungstoleranz des Modelloberflächengitters der Modellkörperkontur liegt. Hierbei kann beispielsweise an einem Bildschirm direkt das Messergebnis ausgegeben werden und somit dem Benutzer annähernd verzögerungsfrei etwaige Fehlerstellen signalisiert werden.

Entsprechend einer vorteilhaften Weiterbildung kann vorgesehen sein, dass während dem Fertigen des Körpers Fertigungsparameter aufgezeichnet werden und in einer Lernphase die Einflüsse der Fertigungsparameter auf die Realkörperkontur durch Auswertung der Abbildung der Realkörperkontur, insbesondere des Realoberflächengitters, des Körpers oder des Speicheroberflächengitters des vermessenen Körpers bestimmt und in einem Einflussmodell abgespeichert werden und dass nach Abschluss der Lernphase die Abbildung, insbesondere das Realoberflächengitter, der Realkörperkontur eines nachfolgend gefertigten Körpers auf Basis der im jeweiligen Fertigungsprozess anliegenden Fertigungsparameter unter Berücksichtigung des Einflussmodells erstellt wird, ohne den Körper zu vermessen. Durch diese Maßnahme ist es möglich, dass in einer Serienfertigung von Bauteilen nicht alle gefertigten Körper tatsächlich vermessen werden müssen, sondern dass das Realoberflächengitter für zumindest einige Körper ausschließlich anhand der Fertigungsparameter erstellt werden kann. Beispielsweise ist es denkbar, dass nach Abschluss der Lernphase kein einziges der weiteren gefertigten Bauteile vermessen wird.

Alternativ dazu ist es auch denkbar, dass nach Abschluss der Lernphase in einem zyklischen oder antizyklischen Abstand bzw. beim Auftreten bestimmter Kriterien die nach Abschluss der Lernphase gefertigten Bauteile vermessen werden. Die Kriterien, welche eine Vermessung des Körpers erforderlich machen können hierbei etwa das Erreichen oder Überschreiten gewisser vorgegebener Toleranzgrenzen der Fertigungsparameter sein.

Somit kann beispielsweise bei Überschreiten einer Toleranzgrenze eines Fertigungsparameters durch Vermessen des Körpers evaluiert werden, ob das Überschreiten der Toleranzgrenze des Fertigungsparameters tatsächlich auch zu einem Überschreiten der Genauigkeitstoleranz des Körpers führt. Weiters ist es auch denkbar, dass die Toleranzgrenzen der Fertigungsparameter auf Basis des Messergebnisses automatisiert angepasst werden. Dadurch braucht beispielsweise ein zukünftig gefertigter Körper, welcher Fertigungsparameter aufweist, die au-ßerhalb der ursprünglichen Toleranzgrenze für Fertigungsparameter, jedoch innerhalb der angepassten Toleranzgrenze für die Fertigungsparameter liegt, nicht mehr vermessen zu werden.

Beim Erstellen des Einflussmodells wird eine große Datenmenge an Fertigungsparametern und die direkte Auswirkung dieser Fertigungsparameter auf das tatsächlich gefertigte Werkstück gesammelt. Hierbei werden auch Zusammenhänge von verschiedenen Fertigungsparametern bzw. deren Einflüsse auf die Fertigung erstellt. Nach Abschluss der Lernphase kann das Ergebnis der tatsächlich aufgetretenen Fertigungsparameter auf Basis der im Einflussmodell abgespeicherten Daten interpoliert werden. Wie oben beschrieben kann das Einflussmodell auch nach Abschluss der Lernphase weiter angepasst werden.

In einer Weiterbildung ist es denkbar, dass beispielsweise nur für eine Vorserie einer Fertigungsmaschine ein Einflussmodell erstellt wird und dass dieses Einflussmodell für die weiteren Fertigungsmaschinen einer Serie nur adaptiert wird, sodass nicht bei jedem einzelnen Fertigungsprozess tatsächlich auch eine Lernphase notwendig ist. Wenn die Fertigungsmaschinen selbst entsprechend den beschriebenen Verfahren vermessen sind, bzw. ein Simulationsmodell erstellt wurde, dann ist es auch denkbar, dass die Anpassungen des Einflussmodells auf Basis dieser Vermessungsdaten vorgenommen werden.

Weiters ist es auch denkbar, dass hierbei an verschiedenen Fertigungsmaschinen einer Serie verschiedene Einflussmodelle erstellt werden und dass die Fertigungsmaschinen miteinander vernetzt sind, wodurch die Einflussmodelle der einzelnen Fertigungsmaschinen angepasst bzw. ergänzt werden können. Insbesondere bei später in einer Serie gebauten Maschinen können beispielsweise die Einflussmodelle um das gewonnene alterungsbedingte Know-How, beispielsweise bezüglich Verschleiß, von früheren in einer Serie gebauten Maschinen ergänzt bzw. angepasst werden.

Natürlich ist es auch denkbar, dass durch Lerneffekte nicht nur das Einflussmodell für die Vorhersage des Aussehens des gefertigten Körpers angepasst wird. Vielmehr ist es auch denkbar, dass durch Lerneffekte von außerhalb der Toleranzgrenze liegenden gefertigten Körpern die Fertigungsparameter angepasst werden. Hierbei können die aus dem Einflussmodell bekannten Zusammenhänge für die Anpassung der Fertigungsparameter verwendet werden.

Weiters kann vorgesehen sein, dass zum Erstellen des Einflussmodells der Fertigungsparameter bzw. zum Erstellen des Realoberflächengitters der Realkörperkontur bzw. zum Abändern der Fertigungsparameter auf Basis des obig beschriebenen Lernprozesses ein künstliches neuronales Netz und/oder Deep Learning Optimierungsmethoden verwendet werden.

Insbesondere kann es vorteilhaft sein, wenn der Körper in einem automatisierten Fertigungsverfahren mittels einer Fertigungsmaschine, die eine PLC-Steuerung aufweist, gefertigt wird, wobei die Fertigungsparameter direkt aus der PLC-Steuerung gewonnen werden. Somit können die Fertigungsparameter einfach ausgelesen werden.

Eine PLC-Steuerung (Programmable Logic Controller) dient zum Steuern der Aktoren einer Fertigungsmaschine. Mittels der PLC-Steuerung können die einzelnen Verfahrensschritte aufeinander abfolgend gesteuert werden. Eine CNC-Steuerung (Computerized Numerical Control) ist eine spezielle Ausführungsvariante einer PLC-Steuerung, in der einzelne Aktorenbewegungen auch überlagert werden können und somit zeitgleich ausgeführt werden können, um beispielsweise eine Bahnsteuerung realisieren zu können.

Alternativ oder zusätzlich dazu kann vorgesehen sein, dass zumindest einzelne Fertigungsparameter mittels zumindest einem Sensor erfasst werden, welcher an einem Bearbeitungswerkzeug, insbesondere an einem handgeführten Bearbeitungswerkzeug, angeordnet oder mit diesem gekoppelt ist. Durch diese Maßnahme kann erreicht werden, dass die Fertigungsparameter um die tatsächlich auftretenden Zustände, welche durch die Sensoren erfasst werden, angepasst werden können bzw. dass mittels der Sensoren die tatsächlich auftretenden Zustände erfasst werden können.

In einem ersten Ausführungsbeispiel kann vorgesehen sein, dass der Sensor direkt am Bearbeitungswerkzeug angeordnet ist.

Insbesondere kann vorgesehen sein, dass eine Datenübertragung zwischen dem Bearbeitungswerkzeug und der Fertigungsmaschine ermöglicht wird. Hierbei kann beispielsweise vorgesehen sein, dass in der Werkzeugaufnahme, wie etwa Steilkegelschaftaufnahme, eines Bearbeitungswerkzeuges in einer Fertigungsmaschine eine Datenverbindungsschnittstelle zur Übertragung von Daten der Sensoren an die Fertigungsmaschine vorgesehen ist.

In einem weiteren Ausführungsbeispiel kann vorgesehen sein, dass der Sensor nicht direkt am Bearbeitungswerkzeug angeordnet ist, sondern an einem das Bearbeitungswerkzeug aufnehmenden Werkzeugträger angeordnet ist. Bei einer derartigen Ausführung kann der Fertigungsparameter des Bearbeitungswerkzeuges mittels des Werkzeugträgers aufgezeichnet werden.

Ein Bearbeitungswerkzeug im Sinne dieses Dokumentes kann beispielsweise ein Werkzeug zur spanabtragenden Bearbeitung, ein Biegewerkzeug, ein Schweißkopf oder ein sonstiges Werkzeug welches zum Beeinflussen der Beschaffenheit des Körpers dient, sein.

Insbesondere kann vorgesehen sein, dass zum Erstellen des Einflussmodells die einzelnen Fertigungsparameter bzw. deren zeitlicher Verlauf miteinander kombiniert werden.

Insbesondere kann vorgesehen sein, dass der Sensor einen Beschleunigungssensor und/oder einen Gyrosensor umfasst, welche zum Erfassen der Position bzw. der Ausrichtung des Bearbeitungswerkzeuges über einen zeitlichen Verlauf hinweg ausgebildet sind.

In einem ersten Ausführungsbeispiel kann vorgesehen sein, dass das Bearbeitungswerkzeug in Form eines Schweißkopfes ausgebildet ist. Insbesondere kann vorgesehen sein, dass als erster Fertigungsparameter bei Erstellung einer Schweißnaht mittels des Sensors die Position bzw. die Ausrichtung des Schweißkopfes während dem Schweißvorgang erfasst wird. Dies ist besonders bei handgeführten Schweißköpfen von Vorteil. Insbesondere kann vorgesehen sein, dass mittels des Sensors ein Schweißwinkel und/oder ein Vorschubwinkel und/oder die Position eines Toolcenterpoints des Schweißkopfes und/oder eine Schweißkopfvorschubgeschwindigkeit erfasst wird.

Weitere Fertigungsparameter, die für die Erstellung einer Schweißnaht relevant sind, können beispielsweise direkt aus den Einstellungen der Schweißmaschine gewonnen werden. Dies kann beispielsweise die Schweißdrahtvorschubgeschwindigkeit, der Schweißdrahtdurchmesser, oder die elektrische Schweißleistung sein. Die elektrische Schweißleistung berechnet sich hierbei aus Schweißspannung und Schweißstrom.

Als Schweißdraht im Sinne dieses Dokumentes wird sowohl der Draht einer Schutzgasschweißvorrichtung verstanden, als auch die Elektrode einer Elektrodenschweißvorrichtung. Bei einer Elektrodenschweißvorrichtung errechnet sich Schweißdrahtvorschubgeschwindigkeit aus der zeitlichen Abstandsänderung des Toolcenterpoints zu den zu verschweißenden Werkstücken.

Weitere Fertigungsparameter können auch per Hand eingegeben werden. Dies kann beispielsweise das zu verschweißende Material der zu einem Körper zu verschweißenden Werkstücke, die Materialstärke der Werkstücke, die Schweißposition, das Material des Schweißdrahtes oder der Schweißdrahtdurchmesser sein.

Die Schweißpositionen beschreiben oder bezeichnen die Lage der Schweißnaht während des Schweißvorgangs. Die Schweißpositionen ergeben sich aus der Lage der zu schweißenden Werkstücke und der Zugänglichkeit des Brenners zur Naht.

Insbesondere kann vorgesehen sein, dass die zu verschweißenden Werkstücke in einer Spannvorrichtung gespannt sind, sodass die Schweißposition eindeutig festgelegt ist.

Darüber hinaus kann vorgesehen sein, dass im CAD eine virtuelle Fertigungsmaschine konstruiert wird und Prozessparameter der virtuellen Fertigungsmaschine, wie beispielsweise eine maximale Vorschubgeschwindigkeit eines Drehmeißels, festgelegt werden und dass die Prozessparameter der tatsächlich gefertigten und vermessenen Fertigungsmaschine, insbesondere durch Einsatz eines künstlichen neuronalen Netzes, selbstlernend auf Basis der Vermessungsdaten angepasst werden. Durch diese Maßnahme kann erreicht werden, dass die Prozessparameter der virtuellen Fertigungsmaschine berechnet bzw. maximiert werden können und diese Prozessparameter in der tatsächlich gefertigten Fertigungsmaschine entsprechend selbstlernend angepasst werden können, um die Effizienz der einzelnen gefertigten Fertigungsmaschinen steigern zu können. Dieser Anpassvorgang kann beispielsweise durch Vernetzung von verschiedenen Fertigungsmaschine einer Baureihe optimiert werden. Insbesondere kann hierbei vorgesehen sein, dass die Fertigungsparameter zum Ausgleich von alterungsbedingten Verschleißzuständen angepasst werden.

In einer ersten Ausführungsvariante kann das Vermessungsmittel ein optisches Erfassungsmittel umfassen. Das optische Erfassungsmittel kann beispielsweise ein Kamerasystem, ein CCD-Sensor, ein Profilprojektor, ein Konfokalmikroskop, ein Weißinterferometer oder ein Rasterkraftmikroskop sein.

Ein optisches Erfassungsmittel in Form eines optischen Rauheitssensors ist beispielsweise in der ISO 25178 beschrieben.

In einer weiteren Ausführungsvariante kann das Vermessungsmittel auch ein taktiles Erfassungsmittel umfassen. Hierbei kann ein Tastkopf, insbesondere eine Tastkugel, zum Abtasten der Oberfläche des Körpers ausgebildet sein.

In wieder einer anderen Ausführungsvariante ist es beispielsweise auch denkbar, dass das Vermessungsmittel einen Wellensensor, beispielsweise einen Ultraschallsensor, umfasst.

Erfindungsgemäß ist ein System zur Datenverarbeitung vorgesehen, umfassend einen Computer mit einer Benutzerschnittstelle und einen Datenträger, sowie ein Vermessungsmittel eine Fertigungsanlage. Das System ist hierbei zur Ausführung der Schritte des erfindungsgemäßen Verfahrens ausgebildet.

Gemäß einer Weiterbildung ist es möglich, dass das Vermessungsmittel ein handgeführtes Erfassungsmittel umfasst. Dies bringt insbesondere den Vorteil mit sich, dass ein handgeführtes Erfassungsmittel flexibel eingesetzt werden kann und keiner vorherigen Programmierung bedarf. Somit können verschiedenartig ausgebildete Körper mit komplexen Bauformen einfach und kostengünstig erfasst werden.

Erfindungsgemäß ist eine Fertigungsanlage umfassend ein erfindungsgemäßes System zur Datenverarbeitung und eine erfindungsgemäße Fertigungsmaschine vorgesehen.

Erfindungsgemäß ist ein Computerprogrammprodukt vorgesehen, umfassend Befehle, die das System zur Datenverarbeitung veranlassen, das erfindungsgemäße Verfahren auszuführen. Erfindungsgemäß ist ein computerlesbares Speichermedium vorgesehen, umfassend Befehle,

die bei der Ausführung durch das System dieses veranlassen, das erfindungsgemäße Verfahren auszuführen.

Ein Oberflächengitter weist mehrere im Raum verteilte Gitterpunkte auf, die durch Gitterlinien miteinander verbunden sind. Die Gitterlinien können gerade sein, oder in Spezialfällen auch in Form von parametrisierten Kurven ausgebildet sein. Insbesondere kann vorgesehen sein, dass ein Dreieckgitter ausgebildet ist. Weiters kann auch ein Polyedergitter, wie etwa ein Rechteckgitter oder ein Sechs oder Achteckgitter ausgebildet sein.

Das Oberflächengitter kann als strukturiertes Gitter mit regelmäßiger Topologie, jedoch nicht notwendigerweise einer regelmäßigen Zellgeometrie ausgebildet sein. Bei strukturierten Gittern liegen die Zellen in einem regelmäßigen Raster vor, so dass sich die Zellen eindeutig durch ganzzahlige Zahlen indizieren lassen.

Weiters ist es auch denkbar, dass das Oberflächengitter als unstrukturiertes Gitter ausgebildet ist. Unstrukturierte Gitter haben keine festgelegte Topologie und keine gleichmäßige Gitterzellgeometrie. Unstrukturierte Gitter sind meist das Ergebnis eines Adaptionsprozesses. Bekannt sind auch Gitter aus komplexen Zellen, sogenannte Polygongitter.

Als Auflösung des Oberflächengitters wird die Feinmaschigkeit des Oberflächengitters bezeichnet. Je feiner die Auflösung des Oberflächengitters ist, desto feiner ist das Oberflächengitter und desto mehr Gitterpunkte sind in einem gewissen Bereich vorhanden. Je feiner die Auflösung des Oberflächengitters ist, desto größer ist auch der benötigte Speicherplatz zum Abspeichern der Daten.

Das Realoberflächengitter ist im Normalfall ein nichtadaptives Gitter, das überall dieselbe Auflösung aufweist. Das Realoberflächengitter kann durch Vermessung des Körpers erstellt werden. Alternativ dazu ist es auch denkbar, dass das Realoberflächengitter auf Basis der Prozessparameter erstellt wird.

Ein Computer im Sinne dieses Dokumentes ist ein Rechner zur Datenverarbeitung. Wird von einem Computer gesprochen, so kann auch ein Zusammenschluss mehrerer Computer gemeint sein. Insbesondere ist es auch möglich, dass einzelne Verfahrensschritte, wie beispielsweise das Erstellen der CAD-Daten des virtuellen Körpers und das Erstellen des Realoberflächengitters auf unterschiedlichen Computern ausgeführt werden, obwohl der Einfachheit halber mit demselben Bezugszeichen auf nur einen Computer verwiesen wird.

Als Speicheroberflächengitter wird das an die Realkörperkontur angepasste Modelloberflächengitter bezeichnet. Insbesondere ist es denkbar, dass hier nicht die Daten des ursprünglich erstellten Modelloberflächengitters überschrieben werden, sondern dass eine Kopie des ursprünglich erstellten Modelloberflächengitters zum Erstellen des Speicheroberflächengitters verwendet wird, um die Daten des Modelloberflächengitters zum Erstellen von weiteren Speicheroberflächengittern von weiteren Körpern bereit zu halten.

Ein gefertigter Körper im Sinne dieses Dokumentes kann ein einteilig gefertigtes Bauteil sein, welcher beispielsweise durch urformen, wie etwa gießen, hergestellt wird. Weiters wird im Sinne dieses Dokumentes als Körper auch ein einstückig gefertigtes Bauteil verstanden, welches beispielsweise durch Verbindung aus mehreren Werkstücken mittels einer Schweißverbindung gefertigt wird.

Darüber hinaus wird im Sinne dieses Dokumentes als Körper auch eine aus mehreren Bauteilen zusammengesetzte Baugruppe verstanden. Hierbei ist es denkbar, dass jedes der Bauteile einzeln vermessen wird, oder dass die Baugruppe im zusammengebauten Zustand vermessen wird.

Beim Diskretisieren der Modellkörperkontur wird aus der Modellkörperkontur des virtuellen Körpers, der bis zu diesem Zeitpunkt durch die Parametrisierung der CAD-Daten im CAD-Programm definiert ist, ein Modelloberflächengitter mit einzelnen Gitterpunkten erzeugt, wobei die einzelnen Gitterpunkte jeweils eindeutig definierte Koordinaten aufweisen und somit unabhängig vom verwendeten CAD-Modell bzw. CAD-Programm gespeichert werden können.

Das CAD-Modell kann gerade Flächen, Hüllflächen von geometrisch bestimmten Volumskörpern und auch Non-uniform rational B-Splines (NURBS) enthalten. NURBS sind mathematisch definierte Kurven oder Flächen.

Weiters ist es auch denkbar, dass für ein Objekt mit definierter konstanter Wandstärke, wie etwa ein Blechbauteil, nur eine Mittelebene bzw. Mittelfläche der Geometrie und zusätzlich die Information bezüglich der Wandstärke abgespeichert wird. Dadurch kann zusätzlich Speicherplatz eingespart werden.

In diesem Dokument werden die Begriffe Oberflächengitter bzw. Körperkontur verwendet, wobei darauf hingewiesen sei, dass der Schutzumfang nicht nur auf Geometriehüllen beschränkt ist, sondern natürlich auch Volumenkörper umfasst sind. Dementsprechend können die Oberflächengitter auch innerhalb der Oberfläche eine räumliche Ausdehnung aufweisen. Insbesondere kann vorgesehen sein, dass beim Vermessen des gefertigten Körpers nicht nur die Oberfläche vermessen wird, sondern auch unter der Oberfläche befindliche Materialeigenschaften, unterschiedliche Materialen und auch Materialfehler erfasst werden können.

Um das Volumen des Körpers darzustellen kann eine räumliche Gitterstruktur, wie etwa ein Polyedergitter, insbesondere ein Tetraedergitter, oder etwa ein Hexaedergitter verwendet werden.

Weiters ist es auch denkbar, dass beispielsweise während dem Erstarren eines Gusswerkstückes mittels einer Thermografie die Temperaturverteilung bzw. der Verlauf der Temperaturverteilung festgehalten wird. Dies kann notwendig sein, da bei einem Gießprozess unterschiedliche Oberflächen eine unterschiedliche Abkühlung aufweisen können. Somit kann es zu unterschiedlichen Abläufen bei der Erstarrung eines Körpers kommen, welche zu unterschiedlichen Gefügezusammensetzungen führen können.

Eine Fertigungsmaschine im Sinne dieses Dokumentes kann jede Maschine sein, welche zum Urformen, Umformen, Fügen oder mechanischen Bearbeiten von Werkstücken dient. Eine Fertigungsmaschine kann beispielsweise eine Gießmaschine, eine Schweißanlage, eine Biegemaschine, eine CNC-Fräsmaschine oder eine CNC-Drehmaschine, ein Bearbeitungszentrum oder eine sonstige Maschine sein. Die Fertigungsmaschine kann rechnergesteuert und somit vollautomatisch ausgebildet sein. Weiters ist es auch denkbar, dass die Fertigungsmaschine durch einen Maschinenbediener gesteuert wird, bzw. dass einzelne Verfahrensschritte manuell ausgeführt werden. Die Fertigungsmaschine selbst kann aus Körpern zusammengesetzt sein, welche entsprechend den erfindungsgemäßen Verfahrensschritten vermessen sind.

Eine Abbildung der Realkörperkontur kann beispielsweise in Form einer Punktewolke von Vermessungspunkten erfolgen. Weiters ist es auch denkbar, dass aus der Abbildung der Realkörperkontur, beispielsweise aus der Punktewolke ein Realoberflächengitter erstellt wird.

Als Realdaten eines Körpers werden Daten zur Beschaffenheit eines Körpers gesehen. Die Realdaten können beispielsweise Geometriedaten, wie etwa Oberflächendaten oder Volumendaten umfassen. Weiters können die Realdaten auch Daten über die Gefügezusammensetzung bzw. die Materialeigenschaften eines Körpers umfassen.

Zum besseren Verständnis der Erfindung wird diese anhand der nachfolgenden Figuren näher erläutert.

Es zeigen jeweils in stark vereinfachter, schematischer Darstellung:
- Fig. 1: den Aufbau eines Ausführungsbeispiels einer Fertigungsanlage;
- Fig. 2: eine perspektivische Ansicht eines Modelloberflächengitters einer Modellkörperkontur;
- Fig. 3: eine perspektivische Ansicht einer Realkörperkontur eines gefertigten Körpers bzw. schematisch angedeutet das Realoberflächengitter der Realkörperkontur;
- Fig. 4: eine perspektivische Ansicht eines Speicheroberflächengitters;
- Fig. 5: einen Aufriss und eine Seitenansicht eines Schweißkopfes;
- Fig. 6: eine Darstellung einer Abweichungstoleranz eines Modelloberflächengitters;
- Fig. 7: ein erstes Ausführungsbeispiel eines Systems zur Datenverarbeitung mit einem handgeführten Messkopf;
- Fig. 8: ein erstes Ausführungsbeispiel eines Systems zur Datenverarbeitung mit einem robotergeführten Messkopf.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

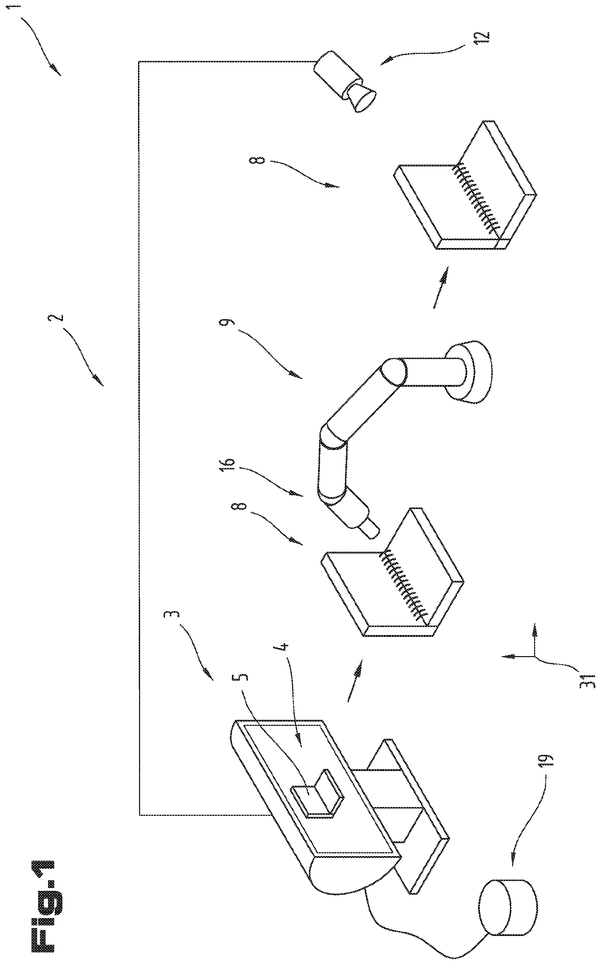

Fig. 1 zeigt einen schematischen Aufbau eines Ausführungsbeispiels einer Fertigungsanlage 1 bzw. eines Systems zur Datenverarbeitung 2, auf welchem das erfindungsgemäße Verfahren ausgeführt werden kann. Das System zur Datenverarbeitung 2 kann Teil der Fertigungsanlage 1 sein.

Weiters kann vorgesehen sein, dass das System zur Datenverarbeitung 2 einen Computer 3 umfasst, welcher in Fig. 1 schematisch durch einen Bildschirm dargestellt ist. Auf dem Computer 3 kann ein CAD Programm ausgeführt werden, mittels welchem CAD Daten eines virtuellen Körpers 4 erstellt werden können. Der virtuelle Körper 4 kann hierbei ein einzelner Körper mit einem monolithischen Aufbau oder auch ein aus mehreren Körpern zusammengesetzter Körper sein.

Eine Modellkörperkontur 5 repräsentiert die Oberfläche des virtuellen Körpers 4.

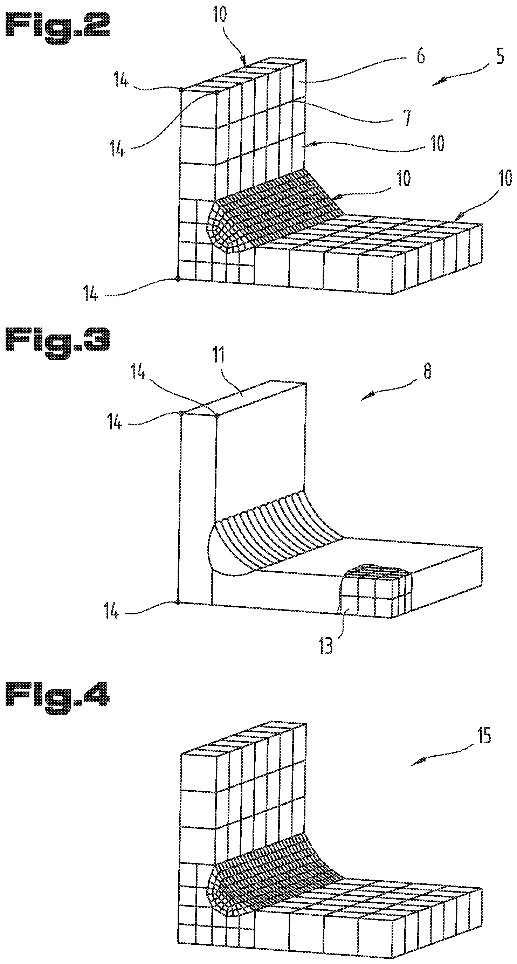

Für die weitere Beschreibung dient eine Zusammenschau der Fig. 1 mit den Figuren 2 bis 4.

In einem weiteren Verfahrensschritt kann auf Basis der Modellkörperkontur 5 ein Modelloberflächengitter 6 diskretisiert werden, welches einzelne Gitterpunkte 7 aufweist, die miteinander verbunden sind. Ein derartiges Modelloberflächengitter 6 ist in Fig. 2 dargestellt. Insbesondere kann hierbei vorgesehen sein, dass einzelne Teilflächen 10 der Modellkörperkontur 5 einzeln diskretisiert werden und zu einem Netz verbunden werden. Hierbei kann vorgesehen sein, dass die einzelnen Modelloberflächengitter 6 der einzelnen Teilflächen 10 der Modellkörperkontur 5 an definierten Schnittstellen miteinander gekoppelt sind. Hierbei können einzelne Gitterpunkte 7 vorgegeben sein, welche zum Koppeln der einzelnen Teile des Modelloberflächengitters 6 dienen. Mit anderen Worten ausgedrückt kann die Modellkörperkontur 5 aus mehreren Teiloberflächengittern zu einem Modelloberflächengitter 6 zusammengesetzt sein.

Auf Basis der CAD Daten des virtuellen Körpers 4 kann im Anschluss an die CAD-Konstruktion ein realer Körper 8 gefertigt werden. Dies kann beispielsweise unter Zuhilfenahme einer Fertigungsmaschine 9 erfolgen. Der Körper 8 weist eine Realkörperkontur 11 auf, welche in Fig. 3 dargestellt ist.

In einem weiteren Bearbeitungsschritt, welcher ebenfalls in Fig. 1 dargestellt ist, kann der gefertigte und somit reale Körper 8 mittels eines Vermessungsmittels 12 vermessen werden. Als Output der Vermessung können die Realdaten des gefertigten Körpers 8 eruiert werden. Insbesondere kann auf Basis der Realdaten, welche durch die Vermessung gewonnen werden können, eine Abbildung der Realkörperkontur 11 erstellt werden. Die Abbildung der Realkörperkontur 11 kann nach dem Vermessen beispielsweise in Form einer Punktewolke vorliegen.

In einer alternativen Ausführungsvariante können die Realdaten des gefertigten Körpers 8 direkt auf Basis von in der Fertigung gewonnen Daten ermittelt werden. Somit kann eine Abbildung der Realkörperkontur 11 direkt auf Basis einer Aufzeichnung von Fertigungsparametern gewonnen werden.

Wie in Fig. 3 schematisch angedeutet, kann vorgesehen sein, dass auf Basis der Vermessungsdaten des Vermessungsmittels 12 ein Realoberflächengitter 13 erstellt wird, welches die Realkörperkontur 11 des Körpers 8 präsentiert. Das Realoberflächengitter 13 weist eine feine Auflösung auf, welches als nicht adaptives Gitter ausgeführt ist und somit über die gesamte Oberfläche oder einen Messbereich verteilt eine gleichmäßige Auflösung aufweist.

In einer weiteren Ausführungsvariante kann auch vorgesehen sein, dass Realkörperkontur 11 des Körpers 8 nur in einem gewissen Messbereich vermessen wird. Dieser Messbereich kann beispielsweise an jenem Bereich des Körpers 8 festgelegt werden, an welchem eine Fertigungsabweichung erwartet wird. Der Rest des Körpers 8 wird hierbei nicht vermessen. Dies bringt den Vorteil mit sich, dass das Vermessen des Körpers 8 beschleunigt erfolgen kann, wenn nicht alle Bereiche des Körpers 8 vermessen werden müssen.

In einem weiteren Verfahrensschritt kann das Realoberflächengitter bezüglich dessen Orientierung in Übereinstimmung mit dem Modelloberflächengitter 6 gebracht werden, was beispielsweise über Referenzpunkte 14 erfolgen kann. Anschließend können die einzelnen Gitterpunkte 7 des Modelloberflächengitters 6 entsprechend dem vermessenen Realoberflächengitter 13 verschoben werden, wodurch, wie in Fig. 4 ersichtlich, ein Speicheroberflächengitter 15 gebildet werden kann.

Das Speicheroberflächengitter 15 ist somit in dessen Auflösung an das Modelloberflächengitter 6 angepasst, weist jedoch die exakte Abbildung der Realkörperkontur 11 des Körpers 8 auf. Somit vereint das Speicheroberflächengitter 15 die Vorteile eines geringen Speicherplatzbedarfes bei gleichzeitig möglichst genauer Abbildung des gefertigten Körpers 8.

Das Speicheroberflächengitter 15 kann auf einem Datenträger 19 abgespeichert werden. Der Datenträger 19 kann hierbei Teil des Computers 3 sein, oder auch ein externer Datenträger 19 sein.

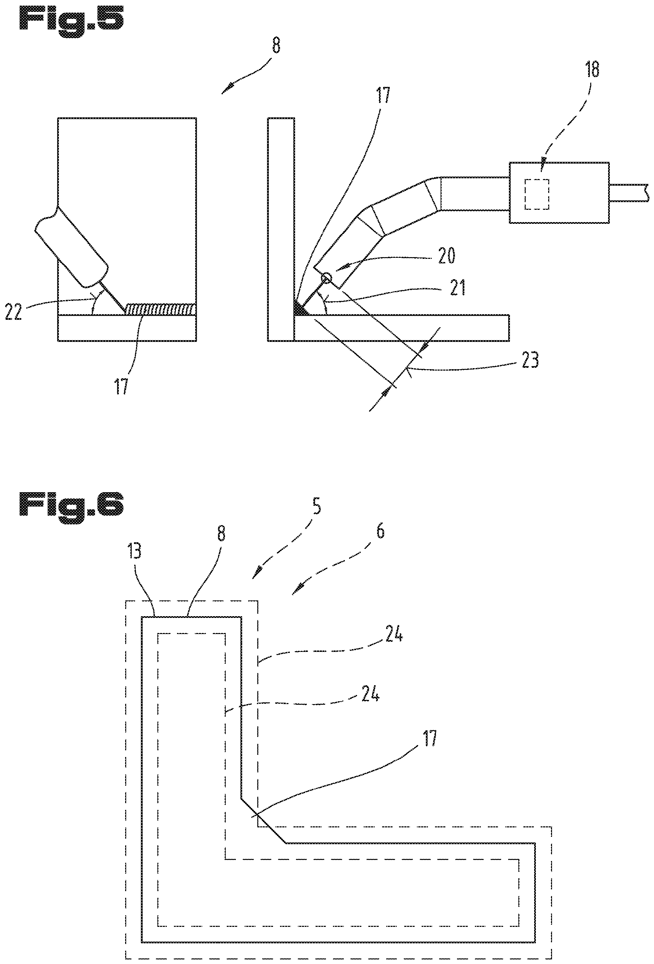

Fig. 5 zeigt den Aufriss und die Seitenansicht des Körpers 8 während der Fertigung. Wie aus Fig. 5 ersichtlich, kann vorgesehen sein, dass zum Fertigen des Körpers 8 ein Bearbeitungswerkzeug 16 eingesetzt wird. Das Bearbeitungswerkzeug 16 kann, wie aus dem Ausführungsbeispiel nach Fig. 5 ersichtlich, in Form eines Schweißkopfes ausgebildet sein. Ein Schweißkopf dient zum Verbinden von zwei oder mehreren Bauteilen mittels einer Schweißnaht 17.

Wie aus dem Ausführungsbeispiel nach Fig. 5 ersichtlich, kann vorgesehen sein, dass am Bearbeitungswerkzeug 16 ein Sensor 18 angeordnet ist, mittels welchem die exakte Ausrichtung bzw. Position des Bearbeitungswerkzeuges 16 über den zeitlichen Verlauf erfasst werden kann. Dadurch kann insbesondere auf die Lage bzw. Ausrichtung eines Toolcenterpoints 20 rückgeschlossen werden. Somit ist es beispielsweise möglich einen Schweißwinkel 21, einen Vorschubwinkel 22 oder einen Schweißkopfabstand 23 vom Schweißgrund zu bestimmen.

Wie aus Fig. 6 ersichtlich, kann vorgesehen sein, dass am Modelloberflächengitter 6 der Modellkörperkontur 5 eine Abweichungstoleranz 24 definiert ist, welche dazu herangezogen werden kann, um zu bestimmen, ob der Körper 8 innerhalb dieser Abweichungstoleranz liegt. Beim Erstellen der Abweichungstoleranz 24 kann beispielsweise das Modelloberflächengitter 6 in einem bestimmten Abstand nach innen bzw. nach außen kopiert werden.

Wenn, wie im Ausführungsbeispiel nach Fig. 6 bei der Schweißnaht 17 der Fall, der Körper 8 außerhalb der Abweichungstoleranz 24 liegt, so kann beispielsweise ein optisches oder ein akustisches Signal abgegeben werden.

Weiters ist es natürlich auch denkbar, dass die Abweichungstoleranz 24 direkt im Modelloberflächengitter 6 hinterlegt ist. Hierbei kann beim Anpassen der Gitterpunkte 7 des Modelloberflächengitters 6 an das Realoberflächengitter 13 bzw. beim direkten Anpassen der Gitterpunkte 7 des Modelloberflächengitters 6 an den vermessenen Körper 8, eine Überschreitung der Abweichungstoleranz 24 dadurch erkannt werden, dass die Gitterpunkte 7 um einen au-ßerhalb der Toleranzgrenze liegenden Wert verschoben werden.

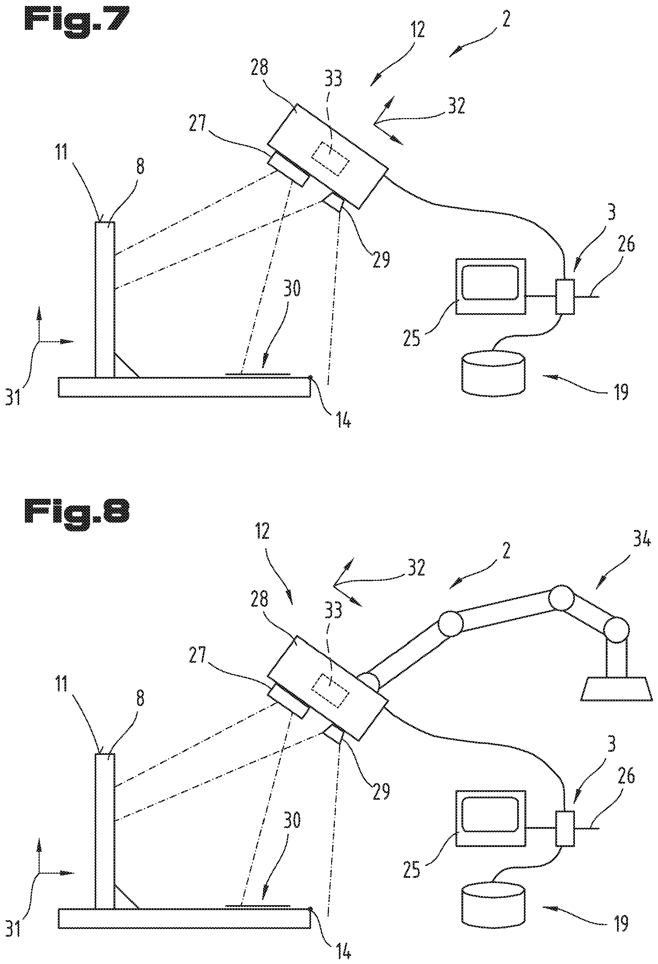

Fig. 7 zeigt ein Ausführungsbeispiel des Systems zur Datenverarbeitung 2. Wie aus Fig. 7 ersichtlich, kann vorgesehen sein, dass das Vermessungsmittel 12 ein optisches Erfassungsmittel 27 umfasst. Insbesondere kann vorgesehen sein, dass das optische Erfassungsmittel 27 an einem Messkopf 28 angeordnet ist. Das optische Erfassungsmittel 27 dient insbesondere zum Erfassen der Realkörperkontur 11 des Körpers 8.

Weiters kann ein Anzeigemittel 25 vorgesehen sein, welches mit dem Computer 3 gekoppelt ist und zur Anzeige von Vermessungsdaten dient. Weiters ist zwischen dem Vermessungsmittel und dem Computer 3 eine Datenverbindung vorgesehen. Diese Datenverbindung kann beispielsweise kabelgebunden oder auch kabellos sein. Weiters kann eine Datenverbindung 26 des Computers 3 zu einem Netzwerk vorgesehen sein.

Wie aus Fig. 7 ersichtlich, kann vorgesehen sein, dass zusätzlich zum optischen Erfassungsmittel 27 ein Referenziermittel 29 am Messkopf 28 angeordnet ist. Das Referenzmittel 29 kann dazu dienen, um die Lage des Körpers 8 über die Referenzpunkte 14 oder eine Referenzfläche zu ermitteln bzw. zu bestimmen.

Weiters ist es auch denkbar, dass am Körper 8 ein Referenzobjekt 30 angeordnet ist, mittels welchem die Lage des Körpers 8 ermittelt werden kann. Das Referenzobjekt 30 kann hierbei beim Herstellen des Körpers 8, beispielsweise beim Gießen, mit diesem hergestellt werden bzw. kann es auch nachträglich auf den Körper 8 aufgebracht werden.

Natürlich ist es auch denkbar, dass das optische Erfassungsmittel 27 und das Referenziermittel 29 in einer Einheit realisiert sind.

Das Referenziermittel 29 kann insbesondere dazu dienen, um die Bewegung des Messkopfes 28 relativ zum Körper 8 zu ermitteln. Hierbei kann die Bewegung des Messkopfes 28 in einem Messkopfkoordinatensystem 32 und die Lage des Körpers 8 in einem Spannkoordinatensystem 31 berechnet werden. Durch Ermitteln der exakten Position des Messkopfes 28 kann mittels des optischen Erfassungsmittels 27 die exakte Lage bzw. Ausgestaltung der Oberfläche des Körpers 8 ermittelt werden.

Alternativ oder zusätzlich zum Referenziermittel 29 kann am Messkopf 28 ein Beschleunigungs- und Gyrosensor 33 angeordnet sein, mittels welchem über den zeitlichen Verlauf exakt die Lage des Messkopfes 28 erfasst werden kann. Ein derartiger Aufbau des Vermessungsmittels 12, wie er in Fig. 7 dargestellt ist, kann beispielsweise handgeführt sein.

Fig. 8 zeigt ein weiteres Ausführungsbeispiel des Systems zur Datenverarbeitung 2. Wie aus Fig. 8 ersichtlich, kann vorgesehen sein, dass das Vermessungsmittel 12, insbesondere der Messkopf 28 mittels eines Robotersystems 34 geführt ist und somit die exakte Lage- bzw. Ausrichtung des Messkopfes 28 zu ihrem Zeitpunkt exakt bestimmbar ist. Bei Verwendung des Robotersystems 34 kann somit das Referenziermittel 29 und/oder der Beschleunigungs- und Gyrosensor 33 optional auch weggelassen werden. Insbesondere wenn die Spannlage des Körpers 8 exakt bekannt ist, kann das Referenziermittel 29 weggelassen werden.

Dem Fachmann ist es klar, dass das optische Erfassungsmittel 27 in den Ausführungsbeispielen nach Fig. 7 und 8 durch sämtliche auf sonstige Weise funktionierende Erfassungsmittel ersetzt werden kann. Auch das Referenziermittel 29 kann verschiedenste Erfassungsmechanismen nutzen.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

**Bezugszeichenaufstellung**

| | | | |
|---|---|---|---|
| 1 | Fertigungsanlage | 30 | Referenzobjekt |
| 2 | System zur Datenverarbeitung | 31 | Spannkoordinatensystem |
| 3 | Computer | 32 | Messkopfkoorinatensystem |
| 4 | virtueller Körper | 33 | Beschleunigungs und Gyrosensor |
| 5 | Modellkörperkontur | 34 | Robotersystem |
| 6 | Modelloberflächengitter | | |
| 7 | Gitterpunkt Modelloberflächengitter | | |
| 8 | Körper | | |
| 9 | Fertigungsmaschine | | |
| 10 | Teilfläche | | |
| 11 | Realkörperkontur | | |
| 12 | Vermessungsmittel | | |
| 13 | Real oberflächengitter | | |
| 14 | Referenzpunkt | | |
| 15 | Speicheroberflächengitter | | |
| 16 | Bearbeitungswerkzeug | | |
| 17 | Schweißnaht | | |
| 18 | Sensor | | |
| 19 | Datenträger | | |
| 20 | Toolcenterpoint | | |
| 21 | Schweißwinkel | | |
| 22 | Vorschubwinkel | | |
| 23 | Schweißkopfabstand | | |
| 24 | Abweichungstoleranz | | |
| 25 | Anzeigemittel | | |
| 26 | Datenverbindung | | |
| 27 | optisches Erfassungsmittel | | |
| 28 | Messkopf | | |
| 29 | Referenziermittel | | |

## Patentansprüche

1. Verfahren zum Speichern von Realdaten einer Realkörperkontur (11) eines Körpers (8), umfassend die Verfahrensschritte:
- Erstellen eines Modelloberflächengitters (6) mit mehreren Gitterpunkten (7), welches Modelloberflächengitter (6) eine Modellkörperkontur (5) abbildet, wobei das Modelloberflächengitter (6) auf Basis von CAD-Daten eines virtuellen Körpers (4) auf einem Computer (3) erstellt wird, wobei zumindest einzelne Teilflächen (10) der Gesamtoberfläche des virtuellen Körpers (4) in einer Gittererzeugung, insbesondere einer adaptiven Gittererzeugung, diskretisiert werden, um insbesondere an unterschiedlichen Teilflächen (10) eine unterschiedliche Auflösung des Modelloberflächengitters (6) zur Verfügung zu stellen;
- Bereitstellen des auf Basis der Modellkörperkontur (5) der CAD-Daten gefertigten Körpers (8);
- Eruieren von Realdaten des gefertigten Körpers (8), wobei die Realdaten des gefertigten Körpers (8) durch Vermessen des gefertigten Körpers (8) in einem Messvorgang mittels eines Vermessungsmittels (12) eruiert werden;
- Erstellen einer Abbildung, insbesondere eines Realoberflächengitters (13), der Realkörperkontur (11) auf Basis der Realdaten und anschließendes anpassen des Modelloberflächengitters (6) der Modellkörperkontur (5) an die Abbildung, insbesondere an das Realoberflächengitter (13), der Realkörperkontur (11) und dadurch Erstellen eines Speicheroberflächengitters (15) zumindest eines Teils der Realkörperkontur (11) mittels des Computers (3);
- Abspeichern des Speicheroberflächengitters (15) auf einem Datenträger (19) zur Weiterverarbeitung der Daten,
wobei das Anpassen des Modelloberflächengitters (6) der Modellkörperkontur (5) an die Abbildung, insbesondere an das Realoberflächengitter (13), der Realkörperkontur (11) durch Verschieben von einzelnen Gitterpunkten (7) des Modelloberflächengitters (6) erfolgt, **dadurch gekennzeichnet, dass** während des Messvorganges das Modelloberflächengitter (6) der Modellkörperkontur (5) direkt an die Messdaten der Realkörperkontur (11) durch Verschieben von einzelnen Gitterpunkten (7) des Modelloberflächengitters (6) an die jeweils vermessene Position der Realkörperkontur (11) angepasst wird und dadurch ein Speicheroberflächengitter (15) der Realkörperkontur (11) mittels des Computers (3) erstellt wird.

2. Verfahren nach Anspruch 1, **dadurch gekennzeichnet, dass** beim Abspeichern des Speicheroberflächengitters (15) die Absolutkoordinaten der Gitterpunkte des Speicheroberflächengitters (15) abgespeichert werden.

3. Verfahren nach Anspruch 1, **dadurch gekennzeichnet, dass** beim Abspeichern des Speicheroberflächengitters (15) die Verschiebungswerte der Gitterpunkte des Speicheroberflächengitters (15) in Relation zum Modelloberflächengitter (6) abgespeichert werden.

4. Verfahren nach einem der vorhergehenden Ansprüche, **dadurch gekennzeichnet, dass** auf Basis des Modelloberflächengitters (6) der Modellkörperkontur (5) eine Simulation durchgeführt wird und dass in einem weiteren Verfahrensschritt das Modelloberflächengitter (6) der Modellkörperkontur (5) durch das Speicheroberflächengitter (15) der Realkörperkontur (11) ersetzt wird und die Simulation mittels der Daten des Speicheroberflächengitters (15) der Realkörperkontur (11) für den jeweiligen gefertigten Körper (8) oder Verbund aus mehreren gefertigten Körpern (8) angepasst oder erneut durchgeführt wird.

5. Verfahren nach einem der vorhergehenden Ansprüche, **dadurch gekennzeichnet, dass** beim Diskretisieren des virtuellen Körpers (4) eine Auflösung des Modelloberflächengitters (6) in jenen Bereichen in denen eine Schweißnaht (17) vorgesehen ist, feiner ist, als eine Auflösung des Modelloberflächengitters (6) in jenen Bereichen des virtuellen Körpers (4), in denen keine Schweißnaht (17) vorgesehen ist.

6. Verfahren nach einem der vorhergehenden Ansprüche, **dadurch gekennzeichnet, dass** dem Anpassen des Modelloberflächengitters (6) der Modellkörperkontur (5) an die Abbildung, insbesondere das Realoberflächengitter (13), der Realkörperkontur (11) ein Verfahrensschritt zum Ausrichten der Abbildung der Realkörperkontur (11) vorgelagert ist, wobei an der Modellkörperkontur (5) zumindest eine Referenzfläche oder Referenzpunkte (14) festgelegt werden, welche am Körper (8) die höchste Fertigungsgenauigkeit aufweisen und dass die Abbildung der Realkörperkontur (11) bezüglich dessen Lage an die Referenzpunkte (14) interpoliert wird, um die Abbildung der Realkörperkontur (11) weitestgehend mit dem Modelloberflächengitter (6) bezüglich dessen Orientierung und/oder Lage auszurichten.

7. Verfahren nach einem der Ansprüche 1 bis 5, **dadurch gekennzeichnet, dass** vor dem Anpassen des Modelloberflächengitters (6) der Modellkörperkontur (5) an die Abbildung, insbesondere das Realoberflächengitter (13), der Realkörperkontur (11) ein Verfahrensschritt zum Ausrichten der Abbildung der Realkörperkontur (11) vorgelagert ist, wobei das Modelloberflächengitter (6) derart bezüglich dessen Orientierung und/oder Lage gedreht und/oder verschoben wird, dass über die Gesamtoberfläche betrachtet ein Abstand zwischen dem Modelloberflächengitter (6) und der Abbildung der Realkörperkontur (11) möglichst gering ist.

8. Verfahren nach einem der Ansprüche 4 oder 5, **dadurch gekennzeichnet, dass** zum Ausrichten oder Einpassen der Abbildung der Realkörperkontur (11) an das Modelloberflächengitter (6) ein Optimierungsalgorithmus, wie etwa ein künstliches neuronales Netz, verwendet wird.

9. Verfahren nach einem der vorhergehenden Ansprüche, **dadurch gekennzeichnet, dass** am Modelloberflächengitter (6) der Modellkörperkontur (5) eine Abweichungstoleranz (24) definiert ist und dass ein Signal ausgegeben wird, wenn die Messwerte des Körpers (8) oder die Abbildung, insbesondere das Realoberflächengitter (13), der Realkörperkontur (11) zumindest bereichsweise außerhalb der Abweichungstoleranz (24) des Modelloberflächengitters (6) der Modellkörperkontur (5) liegt.

10. Verfahren nach einem der vorhergehenden Ansprüche, **dadurch gekennzeichnet, dass** das Vermessungsmittel (12) zum Vermessen des gefertigten Körpers (8) ein optisches Erfassungsmittel (27), insbesondere ein handgeführtes optisches Erfassungsmittel (27), umfasst.

11. Verfahren nach einem der vorhergehenden Ansprüche, **dadurch gekennzeichnet, dass** während dem Fertigen des Körpers (8) Fertigungsparameter aufgezeichnet werden und in einer Lernphase die Einflüsse der Fertigungsparameter auf die Realkörperkontur (11) durch Auswertung der Abbildung der Realkörperkontur (11) oder des Speicheroberflächengitters (15) des vermessenen Körpers (8) bestimmt und in einem Einflussmodell abgespeichert werden und dass nach Abschluss der Lernphase die Abbildung der Realkörperkontur (11) eines nachfolgend gefertigten Körpers (8) auf Basis der im jeweiligen Fertigungsprozess anliegenden Fertigungsparameter unter Berücksichtigung des Einflussmodells erstellt wird, ohne den Körper (8) zu vermessen.

12. Verfahren nach Anspruch 11, **dadurch gekennzeichnet, dass** der Körper (8) in einem automatisierten Fertigungsverfahren mittels einer Fertigungsmaschine (9), die eine PLC-Steuerung aufweist, gefertigt wird, wobei die Fertigungsparameter direkt aus der PLC-Steuerung gewonnen werden.

13. Verfahren nach Anspruch 11 oder 12, **dadurch gekennzeichnet, dass** zumindest einzelne Fertigungsparameter mittels zumindest einem Sensor (18) erfasst werden, welcher an einem Bearbeitungswerkzeug (16), insbesondere an einem handgeführten Bearbeitungswerkzeug (16), angeordnet oder mit diesem gekoppelt ist.

14. Verfahren nach einem der vorhergehenden Ansprüche, **dadurch gekennzeichnet, dass** im CAD eine virtuelle Fertigungsmaschine konstruiert wird und Prozessparameter der virtuellen Fertigungsmaschine, wie etwa eine maximale Vorschubgeschwindigkeit, festgelegt werden und dass die Prozessparameter der tatsächlich gefertigten und vermessenen Fertigungsmaschine, insbesondere durch Einsatz eines künstlichen neuronalen Netzes, selbstlernend auf Basis der Vermessungsdaten angepasst werden.

15. System zur Datenverarbeitung (2), umfassend einen Computer (3) mit einer Benutzerschnittstelle und einen Datenträger (19) und eine Fertigungsmaschine (9), welche zum (9)Fertigen eines Körpers (8) ausgebildet ist, und ein Vermessungsmittel (12), welches insbesondere ein handgeführtes Erfassungsmittel umfasst, und wobei das System zur Ausführung der Schritte des Verfahrens nach einem der vorhergehenden Ansprüche konfiguriert ist.

16. Fertigungsanlage (1) umfassend ein System zur Datenverarbeitung (2) gemäß Anspruch 15.

17. Computerprogrammprodukt, umfassend Befehle, die das System zur Datenverarbeitung (2) des Anspruchs 15 veranlassen, das Verfahren nach einem der Ansprüche 1 bis 14 auszuführen.

18. Computerlesbares Speichermedium, umfassend Befehle, die bei der Ausführung durch ein System nach Anspruch 15 dieses veranlassen, das Verfahren nach einem der Ansprüche 1 bis 14 auszuführen.

## Claims

1. A method for storing real data of a real body contour (11) of a body (8), comprising the method steps:
- creating a model surface grid (6) with multiple grid points (7), said model surface grid (6) representing a model body contour (5), wherein the model surface grid (6) is created in a computer (3) based on CAD data of a virtual body (4), wherein at least individual partial surfaces (10) of the overall surface of the virtual body (4) are discretized in a grid generation, in particular an adaptive grid generation, so as to provide a different resolution of the model surface grid (6) in particular at different partial surfaces (10);
- providing the body (8) manufactured based on the model body contour (5) of the CAD data;
- determining real data of the manufactured body (8), wherein the real data of the manufactured body (8) is determined by measuring the manufactured body (8) in a measuring operation by means of a measuring means (12);
- creating a representation, in particular a real surface grid (13) of the real body contour (11) based on real data and subsequently adapting the model surface grid (6) of the model body contour (5) to the representation, in particular to the real surface grid (13), of the real body contour (11) and thereby creating a memory surface grid (15) of at least a part of the real body contour (11) by means of the computer (3);
- storing the memory surface grid (15) on a data carrier (19) for further processing of the data,
wherein adapting the model surface grid (6) of the model surface contour (5) to the representation, in particular to the real surface grid (13), of the real body contour (11) is carried out by displacing individual grid points (7) of the model surface grid (6), **characterized in that** during the measuring operation, the model surface grid (6) of the model body contour (5) is directly adapted to the measuring data of the real body contour (11) by displacing individual grid points (7) of the model surface grid (6) to the respectively measured position of the real body contour (11) and, thereby, a memory surface grid (15) of the real body contour (11) is generated by means of the computer (3).

2. The method according to claim 1, **characterized in that**, in the course of storing the memory surface grid (15), the absolute coordinates of the grid points of the memory surface grid (15) are stored.

3. The method according to claim 1, **characterized in that**, in the course of storing the memory surface grid (15), the displacement values of the grid points of the memory surface grid (15) in relation to the model surface grid (6) are stored.

4. The method according to one of the preceding claims, **characterized in that**, based on the model surface grid (6) of the model body contour (5), a simulation is carried out and that in a further method step, the model surface grid (6) of the model body contour (5) is replaced by the memory surface grid (15) of the real body contour (11) and the simulation is adapted or carried out again by means of the data of the memory surface grid (15) of the real body contour (11) for the respective manufactured body (8) or composition of multiple manufactured bodies (8).

5. The method according to one of the preceding claims, **characterized in that** during discretization of the virtual body (4), a resolution of the model surface grid (6) is finer in those regions in which a weld seam (17) is provided than a resolution of the model surface grid (6) in those regions of the virtual body (4) in which no weld seam (17) is provided.

6. The method according to one of the preceding claims, **characterized in that** prior to adapting the model surface grid (6) of the model body contour (5) to the representation, in particular the real surface grid (13), of the real body contour (11), there is a method step for aligning the representation of the real body contour (11), wherein at least one reference surface or reference points (14) on the model body contour (5) are determined, which have the highest production accuracy on the body (8) and that the representation of the real body contour (11) is interpolated to the reference points (14) in relation to its position in order to align the representation of the real body contour (11) as far as possible with the model surface grid (6) with respect to its orientation and/or position.

7. The method according to one of claims 1 to 5, **characterized in that** prior to adapting the model surface grid (6) of the model body contour (5) to the representation, in particular the real surface grid (13), of the real body contour (11), there first is a method step for aligning the representation of the real body contour (11), wherein the model surface grid (6) is rotated and/or displaced such in relation to its orientation and/or position that, as viewed across the overall surface, a distance between the model surface grid (6) and the representation of the real body contour (11) is as small as possible.

8. The method according to one of claims 4 or 5, **characterized in that** for aligning or fitting in the representation of the real body contour (11) to the model surface grid (6), an optimization algorithm, such as an artificial neural network, is used.

9. The method according to one of the preceding claims, **characterized in that** a deviation tolerance (24) is defined on the model surface grid (6) of the model body contour (5), and that a signal is output when the measuring values of the body (8) or the representation, in particular the real surface grid (13), of the real body contour (11) is at least in some sections outside the deviation tolerance (24) of the model surface grid (6) of the model body contour (5).

10. The method according to one of the preceding claims, **characterized in that** the measuring means (12) for measuring the manufactured body (8) comprises an optical detection means (27), in particular a hand-guided optical detection means (27).

11. The method according to one of the preceding claims, **characterized in that** during manufacturing the body (8), production parameters are recorded and in a learning phase, the influences of the production parameters on the real body contour (11) is determined by evaluation of the representation of the real body contour (11) or of the memory surface grid (15) of the measured body (8), and are stored in an influence model, and that after completion of the learning phase, the representation of the real body contour (11) of a subsequently manufactured body (8) is created based on the production parameters present in the respective production process, taking into account the influence model, without measuring the body (8).

12. The method according to claim 11, **characterized in that** the body (8) is manufactured in an automated production process by means of a production machine (9) having a PLC control, wherein the production parameters are obtained directly from the PLC control.

13. The method according to claim 11 or 12, **characterized in that** at least individual production parameters are detected by means of at least one sensor (18), which is arranged on a processing tool (16), in particular on a hand-guided processing tool (16), or coupled thereto.

14. The method according to one of the preceding claims, **characterized in that** a virtual production machine is constructed in the CAD and process parameters of the virtual production machine, such as a maximum feed speed, are defined, and that the process parameters of the actually manufactured and measured production machine are adapted in a self-learning manner on the basis of the measuring data, in particular by using an artificial neural network.

15. A system for data processing (2), comprising a computer (3) having a user interface and a data carrier (19) and a production machine (9), which is provided for manufacturing a body (8), and a measuring means (12), which in particular comprises a hand-guided detection means, and wherein the system is configured to carry out the steps of the method according to one of the preceding claims.

16. A production plant (1) comprising a system for data processing (2) according to claim 15.

17. A computer program product comprising commands which cause the system for data processing (2) according to claim 15 to perform the method according to one of claims 1 to 14.

18. A computer-readable storage medium, comprising commands which, upon execution by a system according to claim 15, cause the same to perform the method according to one of claims 1 to 14.

## Revendications

1. Procédé de mémorisation de données réelles d'un contour de corps réel (11) d'un corps (8), comprenant les étapes suivantes :
- création d'une grille de surface de modèle (6) avec plusieurs points de grilles (7), cette grille de surface de modèle (6) représentant un contour de corps de modèle (5), dans lequel la grille de surface de modèle (6) est créée sur la base de données CAO d'un corps virtuel (4) sur un ordinateur (3), dans lequel au moins certaines surfaces partielles (10) de la surface totale du corps virtuel (4) sont discrétisées dans une production de grille, plus particulièrement une production de grille adaptative, afin de mettre à disposition, plus particulièrement au niveau de différentes surfaces partielles (10), une résolution différente de la grille de surface de modèle (6) ;
- mise à disposition du corps (8) fabriqué sur la base du contour de corps de modèle (5) des données CAO ;
- détermination des données réelle du corps fabriqué (8), dans lequel les données réelles du corps fabriqué (8) sont déterminées par mesure du corps fabriqué (8) dans un processus de mesure à l'aide d'un moyen de mesure (12) ;
- création d'une représentation, plus particulièrement d'une grille de surface réelle (13), du contour de corps réel (11) sur la base des données réelles puis adaptation de la grille de surface de modèle (6) du contour de corps de modèle (5) à la représentation, plus particulièrement à la grille de surface réelle (13), du contour de corps réel (11) et création d'une grille de surface de mémoire (15) d'au moins une partie du contour de corps réel (11) au moyen de l'ordinateur (3) ;
- enregistrement de la grille de surface de mémoire (15) sur un support de données (19) afin de traiter les données,
dans lequel l'adaptation de la grille de surface de modèle (6) du contour de corps de modèle (5) à la représentation, plus particulièrement à la grille de surface réelle (13), du contour de corps réel (11) a lieu par déplacement de certains points de grille (7) de la grille de surface de modèle (6),
**caractérisé en ce que**, pendant le processus de mesure, la grille de surface de modèle (6) du contour du corps de modèle (5) est adaptée directement aux données de mesure du contour de corps réel (11) par déplacement de certains points de grille (7) de la grille de surface de modèle (6) vers la position respectivement mesurée du contour de corps réel (11) et une grille de surface de mémoire (15) du contour de corps réel (11) est ainsi créée au moyen de l'ordinateur (3).

2. Procédé selon la revendication 1, **caractérisé en ce que**, lors de l'enregistrement de la grille de surface de mémoire (15), les coordonnées absolues des points de grille de la grille de surface de mémoire (15) sont enregistrées.

3. Procédé selon la revendication 1, **caractérisé en ce que**, lors de l'enregistrement de la grille de surface de mémoire (15), les valeurs de déplacement des points de grille de la grille de surface de mémoire (15) par rapport à la grille de surface de modèle (6) sont enregistrées.

4. Procédé selon l'une des revendications précédentes, **caractérisé en ce que**, sur la base de la grille de surface de modèle (6) du contour de corps de modèle (5), une simulation est effectuée et **en ce que**, dans une étape supplémentaire, la grille de surface de modèle (6) du contour de corps de modèle (5) est remplacée par la grille de surface de mémoire (15) du contour de corps réel (11) et la simulation est adaptée ou à nouveau effectuée au moyen des données de la grille de surface de mémoire (15) du contour de corps réel (11) pour le corps fabriqué (8) correspondant ou un composé de plusieurs corps fabriqués (8).

5. Procédé selon l'une des revendications précédentes, **caractérisé en ce que**, lors de la discrétisation du corps virtuel (4), une résolution de la grille de surface de modèle (6) dans les zones où un cordon de soudure (17) est prévu est plus fine qu'une résolution de la grille de surface de modèle (6) dans les zones du corps virtuel (4) où aucun cordon de soudure (17) n'est prévu.

6. Procédé selon l'une des revendications précédentes, **caractérisé en ce que**, avant l'adaptation de la grille de surface de modèle (6) du contour de corps de modèle (5) à la représentation, plus particulièrement la grille de surface réelle (13), du contour de corps réel (11) est exécutée une étape d'orientation de la représentation du contour de corps réel (11), dans lequel, sur le contour de corps de modèle (5), est définie au moins une surface de référence ou sont définis des points de référence (14) qui présentent, sur le corps (8) la précision de fabrication la plus importante et **en ce que** la représentation du contour de corps réel (11) est interpolée en ce qui concerne sa position au niveau des points de référence (14), afin d'orienter la représentation du contour de corps réel (11) largement avec la grille de surface de modèle (6) en ce qui concerne son orientation et/ou position.

7. Procédé selon l'une des revendications 1 à 5, **caractérisé en ce que**, avant l'adaptation de la grille de surface de modèle (6) du contour de corps de modèle (5) à la représentation, plus particulièrement la grille de surface réelle (13), du contour de corps réel (11), une étape d'orientation de la représentation du contour de corps réel (11) est exécutée, dans lequel la grille de surface de modèle (6) est tournée et/ou déplacée en ce qui concerne son orientation et/ou sa position de sorte que, considérée sur la surface totale, une distance entre la grille de surface de modèle (6) et la représentation du contour de corps réel (11) soit la plus petite possible.

8. Procédé selon l'une des revendications 4 ou 5, **caractérisé en ce que**, pour l'orientation ou l'adaptation de la représentation du contour de corps réel (11) à la grille de surface de modèle (6), on utilise un algorithme d'optimisation, par exemple un réseau neuronal artificiel.

9. Procédé selon l'une des revendications précédentes, **caractérisé en ce que**, sur la grille de surface de modèle (6) du contour de corps de modèle (5), une tolérance d'écart (24) est définie et **en ce qu'**un signal est émis lorsque les valeurs de mesure du corps (8) et la représentation, plus particulièrement la grille de surface réelle (13), du contour de corps réel (11), se trouvent, au moins à certains endroits, hors de la tolérance d'écart (24) de la grille de surface de modèle (6) du contour de corps de modèle (5).

10. Procédé selon l'une des revendications précédentes, **caractérisé en ce que** le moyen de mesure (12) pour la mesure du corps fabriqué (8) comprend un moyen de mesure optique (27), plus particulièrement un moyen de mesure optique (27) guidé manuellement.

11. Procédé selon l'une des revendications précédentes, **caractérisé en ce que**, pendant la fabrication du corps (8), des paramètres de fabrication sont enregistrés et, dans une phase d'apprentissage, les influences des paramètres de fabrication sur le contour de corps réel (11) sont déterminées en analysant la représentation du contour de corps réel (11) ou de la grille de surface de mémoire (15) du corps (8) mesuré et sont enregistrées dans un modèle d'influence et **en ce que**, après la phase d'apprentissage, la représentation du contour de corps réel (11) d'un corps (8) fabriqué ultérieurement est créée sur la base des paramètres de fabrication en cours dans le processus de fabrication correspondant en tenant compte du modèle d'influence, sans mesurer le corps (8).

12. Procédé selon la revendication 11, **caractérisé en ce que** le corps (8) est fabriqué dans un procédé de fabrication automatisé au moyen d'une machine de fabrication (9), qui comprend une commande PLC, dans lequel les paramètres de fabrication sont obtenus directement de la commande PLC.

13. Procédé selon la revendication 11 ou 12, **caractérisé en ce qu'**au moins certains paramètres de fabrication sont mesurés au moyen d'au moins un capteur (18) qui est disposé sur un outil d'usinage (16), plus particulièrement sur un outil d'usinage (16) guidé manuellement, ou couplé avec celui-ci.

14. Procédé selon l'une des revendications précédentes, **caractérisé en ce que**, dans la CAO, une machine de fabrication virtuelle est construite et les paramètres de processus de la machine de fabrication virtuelle, par exemple la vitesse d'avance maximale, sont définies et **en ce que** les paramètres de processus de la machine de fabrication réellement fabriquée et mesurée, sont adaptés par auto-apprentissage sur la base des données de mesure, plus particulièrement grâce à l'utilisation d'un réseau neuronal artificiel.

15. Système de traitement de données (2) comprenant un ordinateur (3) avec une interface utilisateur et un support de données (19) et une machine de fabrication (9), qui est conçue pour la fabrication d'un corps (8) et un moyen de mesure (12), qui comprend plus particulièrement un moyen de mesure guidé manuellement et dans lequel le système est configuré pour l'exécution des étapes du procédé selon l'une des revendications précédentes.

16. Installation de fabrication (1) comprenant un système de traitement de données (2) selon la revendication 15.

17. Produit de programme informatique comprenant des instructions qui font en sorte que le système de traitement de données (2) de la revendication 15 exécute le procédé selon l'une des revendications 1 à 14.

18. Support d'enregistrement lisible par un ordinateur, comprenant des instructions qui, lors de l'exécution par un système selon la revendication 15, font en sorte que celui-ci exécute le procédé selon l'une des revendications 1 à 14.
